Europäisches Patentamt

European Patent Office

Office européen des brevets

(11) Publication number: **0 121 374**
**B1**

## (12) EUROPEAN PATENT SPECIFICATION

(45) Date of publication of patent specification: **02.12.87**

(21) Application number: **84301868.0**

(22) Date of filing: **20.03.84**

(51) Int. Cl.⁴: **H 01 L 23/36, H 01 L 21/48**

(54) Mounting of semi-conductor devices.

(30) Priority: **30.03.83 GB 8308751**

(43) Date of publication of application:
**10.10.84 Bulletin 84/41**

(45) Publication of the grant of the patent:
**02.12.87 Bulletin 87/49**

(84) Designated Contracting States:
**DE FR GB IT**

(56) References cited:
**DE-A-2 802 439**
**GB-A-2 048 567**
**US-A-3 128 419**
**US-A-3 675 089**

(73) Proprietor: **ERA PATENTS LIMITED**
**Cleeve Road**
**Leatherhead Surrey KT22 7SA (GB)**

(72) Inventor: **Walton, Brian**
**5 Heathway Shirley**
**Croydon Surrey (GB)**

(74) Representative: **Jennings, Guy Kenneth et al**
**GILL JENNINGS & EVERY 53-64 Chancery Lane**
**London WC2A 1HN (GB)**

EP 0 121 374 B1

Courier Press, Leamington Spa, England.

# 0 121 374

## Description

In present day electronics with the ever increasing scale of integration at the semi-conductor chip level and faster switching speeds, circuit densities are increasing. There is a need both to keep external inter-connection paths lengths as short as possible and to dissipate the significant amounts of heat generated in the chips. As a result there is intense development activity in the field of packaging and inter-connection with many alternatives to conventional methods being proposed.

For thermal management purposes, substrates capable of withstanding exposure to high temperatures and with higher thermal conductivity than conventional printed circuit boards are required. Copper backed polyimide has been tested as a possible organic-based alternative to fibre glass boards while porcelain enamelled steel and copper clad invar are possible substitutes for alumina ceramic as inorganic substrates suitable for thick film processing. For very high speed integrated circuits in the latest generation of large computers quite complex cooling arrangements employing water cooling, refrigerant gases, helium, spring loaded plungers and so on have been adopted. It is clear that no single ideal solution to the problem has yet emerged and that, moreover, the problem will become more acute with increasing size and density of circuits. Even with forced cooling arrangements some other means of heat removal becomes essential. In theory the mounting of chips on a support of high thermal conductivity would appear to offer a possible solution and the use of highly conductive metal such as copper seems the obvious choice.

Unfortunately copper has a much higher coefficient of thermal expansion than silicon and therefore if chips are mounted directly on a solid copper base undesirable stress and strains will be introduced when the temperature changes. The same problem applies to the use of other metals having a thermal conductivity of the same order as those of copper and its alloys, e.g. in particular, aluminium, gold and silver and their alloys. For the purpose of the present specification, these will be referred to as "metals of high thermal conductivity".

Although it would be possible to avoid this problem, by the use of copper clad invar, since the expansion co-efficient of the composite sheet can be made to match that of silicon or alumina, this would involve a serious penalty in terms of thermal efficiency since copper clad invar has a thermal conductivity some twenty five times lower than that of pure copper when the conductivity is measured in direction normal to the sheet, i.e. through the invar layer. In other words, this would largely negate the advantage of using copper in the first place.

US—A—3,675,089 discloses another solution, namely to deposit an array of metallic, miniscule dot-like projections on an electrically-insulating substrate and to mount the semi-conductor device on the free ends of the projections, so that the differential expansion is accommodated by lateral yielding of the projections. Even though the substrate is selected to have relatively good thermal conductivity, this must be very appreciably less than that of a metal such as copper. One method of depositing the projections on the substrate is to form a coating of the metal and to cut this into a pattern of islands by means of a saw. Since the conductive components of the chip are mounted directly on the projections it is essential that these should be well insulated from one another.

According to the present invention, a substrate for the mounting of a semi-conductor chip or chips and comprising a two-dimensional array of projections for supporting the chip or chips, the projections being formed of a metal of high thermal conductivity separated by saw cuts is characterised by the fact that the projections are in the form of closely spaced narrow pillars extending integrally from a base of the same material, the pillars preferably being rectangular in section and in the form of a uniform array.

With such a form of substrate, the highly conductive pillars, which are integral with a base of highly conductive metal, conduct heat directly to this base which forms a heat sink leading to highly effective cooling. The back surface of the chip, which does not carry conductor tracks nor contain the active circuit elements of the integrated circuit, is bonded to the substrate and it is usually advantageous to have this surface at a common electrical potential. Usually this potential will be the same as that of the metallic substrate but, if necessary, a thin layer of insulation can be provided to make it possible to maintain a potential difference between the substrate and the back of the chip. Such an insulating layer will form only a relatively slight thermal barrier. The provision of closely spaced, narrow pillars ensures effective accommodation of the differential expansion without substantial reduction of the thermal conductivity below that corresponding to a solid substrate.

Exact stress analysis is complex but the reduction in strain is clearly a function of size. Approximate calculations indicate that with a favourable geometry the maximum stress which the pillars can exert on the silicon over a 1 cm length may be reduced by a factor of more than $10^4$ compared to a solid base of the same metal. Thus, the strain in the silicon can be reduced to negligible proportions. There will be some loss in thermal conductivity in the important direction perpendicular to the plane of the silicon slice, but this loss, which will be directly proportional to the amount of metal absent as a result of the spaces between the pillars, will clearly reduce the conductivity by not more than half. Since pure copper, for example, has a thermal conductivity approximately twice that of silicon, ten times that of alumina and twenty five times that of copper clad invar, a copper substrate in accordance with the invention will obviously provide excellent heat conduction.

The invention will now be described in more detail, with reference to the accompanying drawings, in which:—

Figures 1 and 2 are a section and plan view respectively of a copper substrate in accordance with the invention; and

Figure 3 is a sectional view of an assembly including the substrate shown in Figure 1.

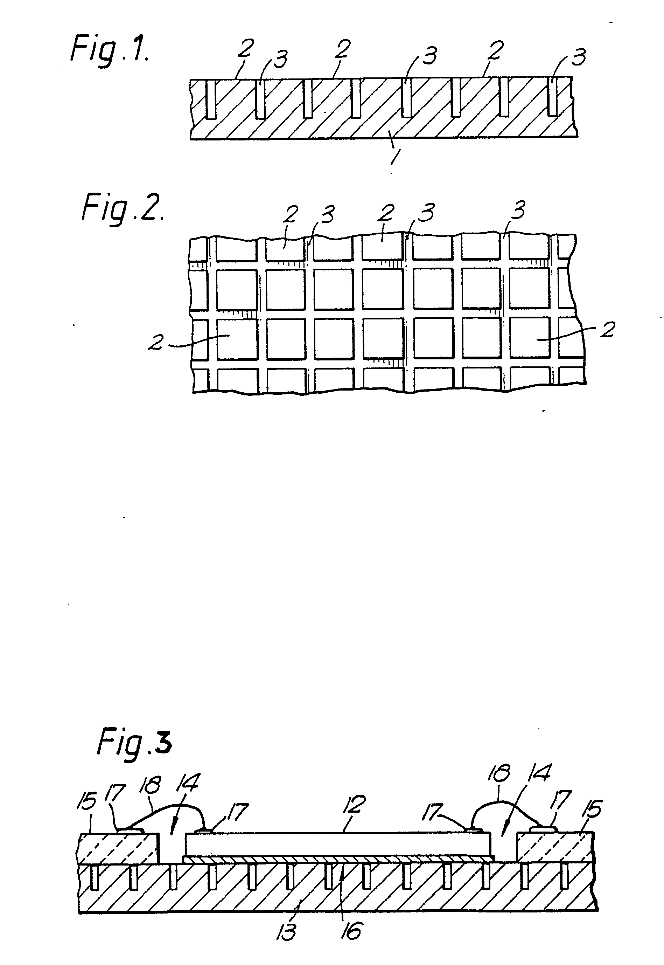

Figures 1 and 2 show part of a substrate in the form of a copper base 1 provided with an array of square-section pillars 2 defined by an orthogonal array of narrow slots 3 which may be cut or etched in the surface. The slots need only be provided beneath the silicon bonding area, but as a matter of convenience, the slots may extend over the whole area of the sheet so that the sheet may be pre-prepared as a stock item. If the slots extend over the whole area this leads to a slight loss in mechanical stiffness, but this can easily be compensated for.

The thickness of the copper sheet is not critical, but the total thickness will typically be in the range 0.5 mm to 5.0 mm. The width, depth and spacing of the slots can be varied to suit the size and thickness of the silicon to be mounted and the degree of stress relief required. A copper substrate with deep, closely spaced slots will provide a more flexible support than a substrate with shallow, widely spaced slots, but typical examples are slot width 0.1 mm, depth 0.4 mm, spacing 0.4 mm. Quite apart from the main advantages of such a substrate, i.e. as already discussed, an additional benefit lies in the avoidance of air entrapment during the actual attachment of the chip, which is often a problem in bonding over large areas.

Substrates in accordance with the invention are suitable for use with a wide range of assemblies and mounting arrangements, an example of which is shown in Figure 3.

Figure 3 shows a chip 12 mounted on a copper substrate 13, according to Figure 2.

The mounting may be either directly or if necessary, with a thin insulating layer at the interface. The chip sits in a "well" 14 surrounded by a layer 15 of glass ceramic material previously applied by screen printing and firing which is approximately the same thickness as the chip itself. Connection between pads 17 on the chip 12 and on copper metallisation on the surface of the glass ceramic is made by a wire 18 using conventional wire bonding techniques. Co-planar chip and ceramic surfaces facilitate this bonding step. The relatively large thickness of glass ceramic reduces capacitive coupling between conductor lines on the surface via the metallic substrate.

As mentioned originally, copper has a much higher co-efficient of thermal expansion ($16.7 \times 10^{-6} \, ^\circ C^{-1}$) than silicon (C. $2.7 \times 10^{-6} \, ^\circ C^{-1}$) so that at a bonded interface between layers of the two materials a differential strain will be set up when a temperature change occurs. If the copper is a relatively massive continuous body compared to the silicon most of the strain will appear in the latter, and for a temperature change of 100°C the magnitude of the strain in the silicon will therefore be up to a maximum value of 0.14%. Although for very small chips (i.e. for those where the thickness of the silicon is of the same order of magnitude as the length of the sides) such a strain may be safely accommodated by a slight distortion in the shape of the chip, for larger chips the use of a slotted copper substrate reduces the strain in the silicon to an acceptable level.

In order to demonstrate the practical utility of a substrate in accordance with the invention, tests were carried out as described in the following example.

Example

50 mm squares of silicon wafer approximately 0.375 mm thick were bonded to plain copper sheets, and to copper sheets the surface of each of which had an orthogonal array of slots cut into it by means of a numerically controlled milling machine. The slot dimensions were depth 1.4 mm, width 0.25 mm, separation 0.40 mm. A silver loaded epoxy resin adhesive of the type commonly used for bonding silicon chips to substrates was employed. This was cured at 150°C for one hour. Miniature foil-type strain gauges of 120 ohm nominal resistance and a gauge factor of 2.0 were bonded to the surface of the silicon squares mounted on the plain copper and slotted copper and also onto a control sample of unmounted silicon. The resistance of each strain gauge was measured at room temperature and again at approximately 120°C, and the equivalent thermally induced strain calculated. The results are given in the following table.

TABLE

| Test sample | Temperature internal (°C) | Change in gauge resistance (mΩ) | Equivalent thermally induced strain (ppm/°C) |
|---|---|---|---|
| Silicon Control (unmounted) | 98 | .174 | 0 |
| Silicon on Plain Copper | 98 | +10 | 7.5 |
| Silicon on Slotted Copper | 98 | −170 | 0.2 |

3

Once the strain in the silicon has been reduced to an acceptable level, the remainder of the assembly presents no problems. Thus a wide variety of glass ceramic compositions exist including high co-efficient of expansion materials such as the $LiO_2$—$2nO$—$SiO_2$ system which also has a high bulk resistivity. Successful atmosphere firing techniques for copper and matching dielectric layers have already been developed and suitable equipment is available. Thick film copper compositions which are both solderable and wire bondable are commercially available and although these are designed for firing on alumina, modified compositions which satisfactorily match a copper based system may also be produced. A number of approaches to the requirement for very fine inter-connection lines are available including etching of thin or thick films and the "mid-film" technique.

Although the detailed examples have been described in terms of the use of copper, it has already been pointed out that a number of other metals and their alloys may be used in a similar way, with an appropriate adjustment of the other parameters involved. Silver and aluminium in particular may be regarded as practical alternatives to copper, and gold may also be used in circumstances where the expense can be justified.

**Claims**

1. A substrate for the mounting of a semi-conductor chip or chips (12), and comprising a two-dimensional array of projections (2) for supporting the chip or chips, the projections being formed of a metal of high thermal conductivity, and separated by saw cuts (3) characterised in that the projections (2) are in the form of closely spaced narrow pillars extending integrally from a base (1) of the same metal.

2. A substrate according to claim 1 in which the metal is copper.

3. A substrate according to claim 1 or claim 2, in which the pillars (2) are rectangular in section and in the form of a uniform array.

4. A method of forming a substrate for the mounting of a semi-conductor chip or chips in which an array of slots (3) is cut by saw in a layer of metal of high conductivity to yield a two-dimensional array of projections (2) characterised in that the layer forms the upper portion of a solid body (1) of the metal and the saw-cuts are sufficiently deep that the resultant projections are in the form of closely spaced narrow pillars extending integrally from a continuous base.

**Patentansprüche**

1. Substrat zum Befestigen eines Halbleiterbauelements (Chip oder Chips 12) mit einer zweidimensionalen Anordnung von Vorsprüngen (2) zum Tragen des bzw. der Chips, wobei die Vorsprünge aus einem Metall mit hoher Wärmeleitfähigkeit geformt und durch Sägeeinschnitte (3) getrennt sind, dadurch gekennzeichnet, daß die Vorsprünge (2) die Form dicht beabstandeter enger Pfeiler besitzen, die sich integral von einer Grundfläche (1) des gleichen Metalls erstrecken.

2. Substrat nach Anspruch 1, dadurch gekennzeichnet, daß das Metall Kupfer ist.

3. Substrat nach Anspruch 1 oder 2, dadurch gekennzeichnet, daß die Pfeiler (2) im Schnitt rechteckig und in Form einer einheitlichen Anordnung sind.

4. Verfahren zum Formen eines Substrates zum Befestigen eines Halbleiterelements (Chip oder Chips), bei dem eine Anordnung von Schlitzen (3) durch eine Säge in eine Metallschicht hoher Leitfähigkeit geschnitten wird, um eine zweidimensionale Anordnung von Vorsprüngen (2) zu erzeugen, dadurch gekennzeichnet, daß die Schicht den oberen Teil eines festen Metallkörpers (1) bildet, und daß die Sägeeinschnitte ausreichend tief sind, daß die entstandenen Vorsprünge die Form dicht beabstandeter, enger Pfeiler besitzen, die sich integral von einer kontinuierlichen Grundfläche erstrecken.

**Revendications**

1. Substrat pour le montage d'une puce ou de puces semi-conductrices (12), et comprenant un réseau à deux dimensions de saillies (2) destiné à supporter la puce ou les puces, les saillies étant formées d'un métal à haute conductibilité thermique, et séparées par des traits de scie (3), caractérisé en ce que les saillies (2) se présentent sous la forme de piliers étroits et rapprochés partant d'une embase (1) du même métal, avec laquelle ils sont réalisés d'une seule pièce.

2. Substrat selon la revendication 1, dans lequel le métal est du cuivre.

3. Substrat selon la revendication 1 ou la revendication 2, dans lequel les piliers (2) sont de section rectangulaire et sous la forme d'un réseau uniforme.

4. Procédé de formation d'un substrat pour le montage d'une puce ou de puces semi-conductrices, dans lequel un réseau de rainures (3) est découpé à la scie dans une couche de métal à haute conductibilité pour former un réseau à deux dimensions de saillies (2), caractérisé en ce que la couche forme la partie supérieure d'un corps plein (1) du métal et les traits de scie sont suffisamment profonds pour que les saillies résultantes se présentent sous la forme de piliers étroits et rapprochés partant d'une embase continue avec laquelle ils sont réalisés d'une seule pièce.

**0 121 374**

Fig.1.

Fig.2.

Fig.3